# FASCICULE DE BREVET EUROPEEN

(11) **EP 1 451 771 B1**
(45) Date de publication et mention de la délivrance du brevet: **17.08.2005**
(21) Numéro de dépôt: 02783426.6
(22) Date de dépôt: 21.11.2002
(51) Int. Cl.: G06K 19/077

(54) **METHODE DE FABRICATION D'UN MODULE COMPRENANT AU MOINS UN COMPOSANT ELECTRONIQUE**
HERSTELLUNGSVERFAHREN FÜR EIN MODUL MIT MINDESTENS EINEM ELEKTRONISCHEN ELEMENT
METHOD FOR MAKING A MODULE COMPRISING AT LEAST AN ELECTRONIC COMPONENT

(30) Priorité: 23.11.2001 CH 216101
(43) Date de publication de la demande: 01.09.2004
(73) Titulaire: Nagraid SA, 2301 La Chaux-de-Fonds (CH)
(72) Inventeur: DROZ, François, CH-2300 La Chaux-de-Fonds (CH)
(74) Mandataire: Wenger, Joel-Théophile
(86) Numéro de dépôt international: PCT/IB2002/004936
(87) Numéro de publication internationale: WO 2003/044733

(56) Documents cités:
- DE-A- 19 625 228
- US-A- 4 961 893
- US-A- 5 272 374
- US-A- 5 416 358
- PATENT ABSTRACTS OF JAPAN vol. 016, no. 410 (M-1302), 28 août 1992 (1992-08-28) -& JP 04 138296 A (MITSUBISHI ELECTRIC CORP), 12 mai 1992 (1992-05-12)

## Description

La présente invention est du domaine des procédés de fabrication d'un module électronique comprenant une couche formée par un liant et au moins un composant électronique.

L'invention concerne des modules fabriqués par remplissage d'un moule par un liant, ces modules comprenant au moins un composant électronique. Un composant électronique est défini ici comme un élément tel qu'une puce, un transpondeur, un circuit intégré, une capacité, une résistance, un fusible, une batterie, des cellules solaires, un affichage, un contrôleur d'empreintes digitales ("fingertip"), un interrupteur, un clavier, ou tout autre élément similaire. Le composant électronique peut être également un circuit électronique formé par la connexion d'une pluralité d'éléments tels que cités précédemment.

Les modules électroniques fabriqués de la sorte comportent au moins une face plane et une seconde face en général parallèle à la première d'où affleure la partie visible du composant électronique. Leur contour est de forme quelconque. Leur épaisseur est proche de celle du composant électronique le plus haut. Les composants sont noyés entièrement ou partiellement dans une masse isolante rigide formée par un liant solidifié. La forme extérieure du module est définie par le moule dans lequel est introduit le liant lors de la fabrication du module.

Ces modules sont en général destinés à des applications qui exigent une grande robustesse mécanique, une certaine résistance aux contraintes de l'environnement (corrosion, pression, température, humidité) et une inviolabilité (difficulté de démontage ou de piratage). Ces modules peuvent, par exemple, constituer des moyens de contrôle, d'identification, d'enregistrement / restitution de données sophistiqués ou des composants d'appareils tels que des ordinateurs, des automates de commande, des blocs d'alimentation électrique etc.

Le sujet de la présente invention se concentre particulièrement sur la méthode de fabrication de ces modules. Il est connu de l'homme du métier des modules obtenus par des procédés d'enrobage de circuits électronique où un liant est coulé dans un moule contenant le circuit. Après durcissement du liant, le module est extrait du moule. La forme et les dimensions du module sont définies par celles données au moule. Par exemple, le document US5416358 décrit un module plat qui comprend un cadre qui entoure une plaquette de circuit imprimé où sont montés des composants électroniques. Le cadre est muni d'orifices latéraux destinés à l'injection de résine de remplissage (liant). Chaque face du cadre est recouverte par au moins une feuille isolante qui peut comporter un décor. Le module ne comporte aucun composant apparent sur l'une de ses faces. Tous les composants sont montés sur un circuit imprimé qui est déposé dans le cadre pour être enrobé par une résine.

Les documents US4961893 et FR2630843 décrivent un procédé de surmoulage d'une carte utilisant un moule en deux parties, l'une fixe et l'autre mobile, définissant une empreinte qui donne la forme extérieure de la carte. Une feuille de support en matière isolante est pincée entre les deux parties du moule constituant une séparation du volume formé par les cavités des parties fixe et mobile lorsque le moule est fermé. Des composants électroniques sont collés sur la face de la feuille de support en regard de la partie fixe du moule. Une matière plastique de remplissage est injectée, par des orifices adéquats, dans le volume délimité par la partie fixe et la feuille de support. Cette dernière est plaquée sur les parois de la cavité de la partie mobile sous la pression de la matière injectée. Les composants sont ainsi partiellement noyés dans la masse de la matière de remplissage. Lors du démoulage de la carte, la feuille de support adhère à la partie mobile du moule. Les faces des composants collés auparavant sur la feuille de support apparaissent ainsi sur la face de la carte.

Ce procédé est particulièrement adapté à la fabrication de cartes de faible épaisseur comportant au moins un composant présentant une face d'accès tels qu'un module à contacts. Une pression relativement élevée est alors nécessaire pour l'injection de la matière de remplissage afin de plaquer la feuille de support, sur laquelle sont collés les composants, contre les parois du moule.

Dans une variante du procédé décrit ci-dessus, le positionnement des composants s'effectue par aspiration au travers d'orifices pratiqués dans le moule (vacuum) en particulier sur les deux faces planes du moule. L'application de cette méthode nécessite un moule sophistiqué connecté à un système d'aspiration d'air, ce qui demande une mise en oeuvre délicate.

Ces procédés connus nécessitent des étapes onéreuses et relativement longues qui empêchent la production de modules en très grandes séries. Plus particulièrement, des difficultés apparaissent au niveau du maintien des composants électroniques durant les phases de préparation du moule et lors du coulage du liant. En effet, certains composants doivent être situés dans une position bien définie dans le module final surtout lorsqu'une face du composant apparaît sur une des faces du module. Par exemple un affichage, des cellules solaires et un circuit intégré ont une place déterminée notamment par le fonctionnement prévu pour le module.

Une autre méthode utilise une structure de positionnement comportant des fenêtres dans lesquelles sont logés les composants. Cette structure est disposée dans la cavité du moule avant le coulage du liant.

Selon le document EP 0 650 620, il est décrit une méthode utilisant une structure de positionnement compressible qui maintient les composants électroniques entre deux plaques de pressage lors de l'apport du liant.

Les méthodes utilisant une structure de positionnement sont bien adaptées pour les modules comportant des composants électroniques entièrement noyés dans la masse du liant comme par exemple dans le cas des cartes à puce sans contact.

Certains modules comportent des composants électroniques dont une face doit apparaître sur la surface du module. Ces cas se présentent pour des composants tels qu'un affichage, des cellules solaires, des touches de clavier etc. Les méthodes décrites ci-dessus sont difficilement applicables car le liant peut s'écouler sur la surface du composant qui doit rester visible sur une face du module. En effet un espace peut subsister entre la face du composant et le fond de la cavité du moule. Cet espace se forme par les défauts de planéité de la surface du composant et de la face du moule contre laquelle s'appuie le composant. Le liant s'écoule alors dans cet espace par effet de capillarité, ou par aspiration dans le cas où le composant serait maintenu dans le moule par vacuum. La face utile du composant concerné est alors détériorée.

Le but de la présente invention est de pallier les inconvénients décrits ci-dessus en proposant une méthode de fabrication de modules peu onéreuse tout en se prêtant à une production en grande série. Ceci concerne en particulier le positionnement dans le moule des composants électroniques qui doit être maintenu tout au long du processus de fabrication du module tout en garantissant l'intégrité de la surface apparente desdits composants sur l'une et/ou l'autre face du module.

Ce but est atteint par un procédé de fabrication d'un module électronique comprenant au moins un composant électronique et une couche formée par un liant, le composant électronique étant partiellement noyé dans la masse rigide formée par le liant solidifié, présente une face apparente à la surface du module, les faces extérieures dudit module étant sensiblement planes, caractérisé en ce qu'il comporte les étapes suivantes:
- disposer une feuille de protection sur une plaque de base,
- poser un cadre sur ladite feuille de protection, ledit cadre définit la forme finale du module, l'épaisseur du cadre est déterminée par la hauteur maximale du composant électronique,
- poser sur la feuille de protection et à l'intérieur du cadre au moins un composant électronique, la position dudit composant étant maintenue par adhésion sur la feuille de protection,
- superposer sur le composant électronique un matériau compressible en recouvrant tout ou partie dudit composant électronique,
- appuyer une plaque de pressage sur le pourtour du cadre, ladite plaque exerçant une pression sur le matériau compressible,
- introduire un liant entre la feuille de protection et la plaque de pressage au travers d'orifices prévus à cet effet dans le cadre, ledit liant enrobant le composant électronique, et remplissant l'espace défini par le cadre, la feuille de protection et la plaque de pressage,
- solidifier le liant, ledit liant formant une couche rigide maintenant le composant électronique,
- enlever la plaque de base et la plaque de pressage après solidification du liant.

La feuille de protection utilisée dans la méthode ci-dessus consiste en un film de matière plastique en général recouvert d'une substance adhésive sur tout ou partie de sa surface. Il a la particularité d'offrir un collage provisoire et non permanent des composants appliqués à sa surface. De plus, cette feuille s'applique sur la surface du composant de manière à obstruer tous les espaces résiduels qui pourraient laisser passer le liant entre la feuille de protection et la surface du composant. L'enlèvement de cette feuille, à la fin du processus de fabrication du module reste aisé, la couche collante de la surface du film ne laisse aucune trace sur le composant.

Une autre forme de réalisation de la feuille de protection est dépourvue de substance adhésive grâce au fait qu'elle consiste en une feuille non absorbante, par exemple à base de caoutchouc ou de silicone. Le composant électronique, appliqué sur la feuille par pression, s'enfonce légèrement dans l'épaisseur de la feuille, ce qui assure l'étanchéité au liant nécessaire à la protection de la surface du composant. Cette pression est obtenue par le placement d'un matériau compressible placé sur le composant électronique et qui vient en appui sur la plaque de pressage.

Cette méthode facilite en outre la fabrication de modules en séries importantes en permettant une superposition des moules. Cet avantage apparaît par la préparation d'un empilement des éléments: plaque de base, feuille de protection, cadre, composant, plaque de pressage, avant l'étape d'injection du liant.

Selon une première variante du procédé, un matériau compressible peut être superposé sur le composant électronique afin d'en améliorer la tenue lorsque sa fixation sur la feuille de protection se révèle insuffisante. Ce cas se présente particulièrement pour un composant de poids relativement élevé comme une batterie ou un affichage placé loin des bords du module, respectivement des bords du cadre. De plus, lors de la fabrication en série, pour des raisons pratiques de montage et pour limiter l'encombrement, les moules sont disposés de préférence verticalement. Le composant ne doit donc pas quitter sa position sous l'effet de la gravité.

Selon une autre variante du procédé, une feuille de matière isolante munie de fenêtres, appelée ici structure de positionnement, peut être disposée sur la feuille de protection. Les composants électroniques sont logés dans les fenêtres et une des faces des composants est appliquée contre la feuille de protection. Les dimensions des fenêtres correspondent à celles du contour des composants. Ce maintien supplémentaire serait utilisé par exemple pour un grand nombre de composants de taille inégale. Dans cette variante un matériau compressible comme décrit précédemment peut aussi recouvrir l'ensemble des composants afin d'améliorer leur maintien dans le moule.

L'invention sera mieux comprise grâce à la description détaillée qui va suivre et qui se réfère aux dessins annexés qui sont donnés à titre d'exemple nullement limitatif, dans lesquels:
- la figure 1 représente une vue générale d'un posage servant à la fabrication d'un module
- la figure 2 montre une coupe du posage de la figure 1.
- la figure 3 représente une vue générale d'un posage avec un matériau compressible.
- la figure 4 montre une coupe du posage de la figure 2.
- la figure 5 représente une vue générale d'un posage avec un matériau compressible disposé dans une demi-coque
- la figure 6 montre une coupe du posage de la figure 5.
- la figure 7 illustre une variante de la figure 4 avec un matériau compressible étendu
- la figure 8 illustre une coupe d'un posage comprenant une structure de positionnement.
- la figure 9 illustre une coupe d'un posage comprenant une structure de positionnement et un matériau compressible
- la figure 10 illustre une coupe d'un posage comprenant une structure de positionnement à l'intérieur du cadre.
- la figure 11 montre un posage avec deux composants superposés et séparés par un matériau compressible

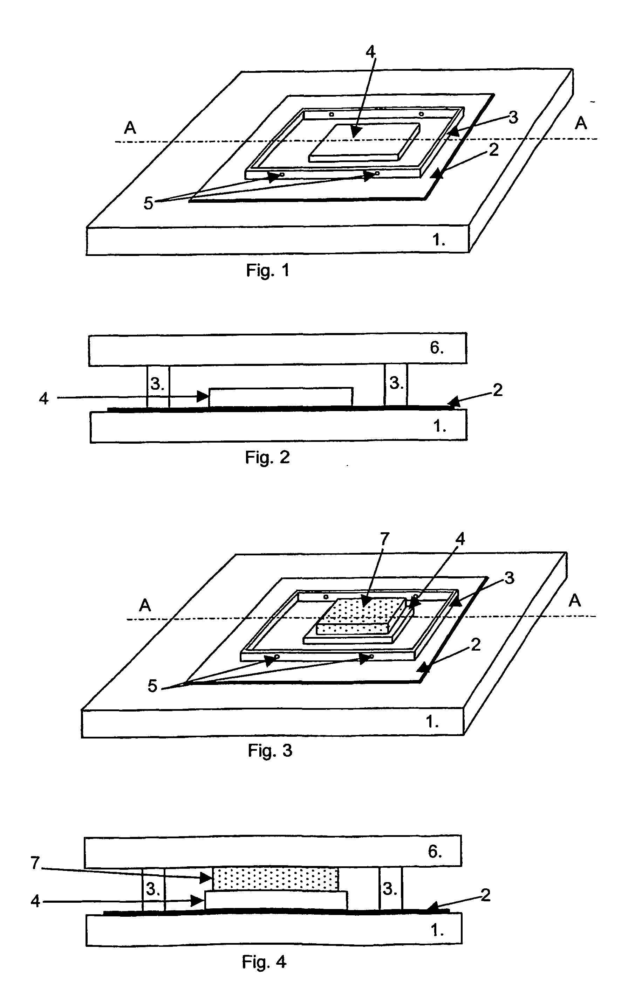

La figure 1 montre un exemple de disposition des éléments servant à la fabrication d'un module. Une feuille de protection (2) est posée sur une plaque de base (1). Un cadre (3) est posé sur la feuille de protection (2). Un composant électronique (4) est disposé à l'intérieur du cadre (3) à l'emplacement prédéterminé par la configuration du module. Ce composant adhère à la feuille de protection (2), ce qui maintient sa position durant toutes les phases du procédé de fabrication. Le cadre (3) définit la forme finale du module, son épaisseur est au moins égale à la hauteur maximale du composant (4).

La figure 2 est une coupe selon l'axe A-A du posage de la figure 1, sur lequel une plaque de pressage (6) est posée sur le cadre (3). La plaque de base (1), le cadre et la plaque de pressage (6) constituent un moule. Le liant est injecté au travers d'orifices (5) pratiqués à cet effet dans le cadre (3) et remplit tout l'espace autour du composant (4) délimité par les parois intérieures du moule. Ces dernières sont formées par la feuille de protection (2) recouvrant la plaque de base (1), les parois internes du cadre (3) et la face interne de la plaque de pressage (6). En général l'épaisseur du cadre est supérieure à la hauteur du composant de façon à laisser un espace entre ce dernier et la plaque de pressage. Le liant peut ainsi recouvrir la face ainsi dégagée du composant.

La figure 3 illustre une variante de la méthode selon l'invention dans laquelle un matériau compressible (7) est superposé sur le composant (4). L'épaisseur du matériau compressible (7) est choisie de façon à ce que la hauteur totale atteinte par le composant recouvert par le matériau compressible soit égale ou plus grande que l'épaisseur du cadre (3).

La figure 4 représente une coupe du posage de la figure 3 selon l'axe A-A avec la plaque de pressage (6) par laquelle est exercée une pression sur le composant (4) par l'intermédiaire du matériau compressible (7). Le maintien du composant électronique (4) dans le moule est ainsi amélioré. Le matériau compressible (7) est constitué par une mousse en matière plastique, une feuille ondulée ou autre matière ayant une élasticité adéquate. Le liant introduit dans le moule est absorbé par ce matériau en général poreux comme la mousse par exemple, et remplit l'espace libre dans le moule.

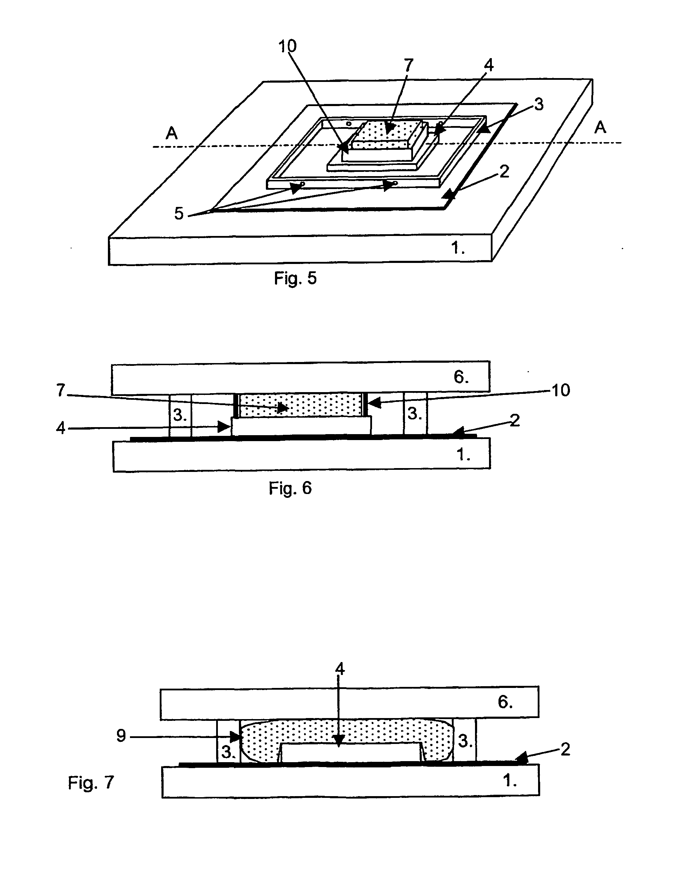

La figure 5 montre une variante de la figure 3 où le matériau compressible (7) est disposé à l'intérieur d'une demi-coque (10) qui se place sur le composant électronique (4).

La figure 6 représente une coupe du posage de la figure 5 selon l'axe A-A avec la plaque de pressage (6). La hauteur des parois de la demi-coque (10) correspond à la hauteur de l'espace séparant le composant électronique (4) de la plaque de pressage (6). Une pression est exercée sur le composant (4) par la plaque de pressage (6) et par l'intermédiaire du matériau compressible (7) dont l'épaisseur est plus grande que la hauteur des parois de la demi-coque (10). Le liant introduit dans le moule se répartit dans tout l'espace libre délimité par les parois du cadre (3), les plaques de base (1) et de pressage (6) et les parois de la demi-coque (10). Le liant ne pénètre donc pas à l'intérieur de la demi-coque (10) où se trouve le matériau compressible (7). Après durcissement du liant, les plaques de base (1) et de pressage (6) sont démontées et le matériau compressible (7) est enlevé de l'intérieur de la demi-coque (10). Le module ainsi obtenu comporte sur une de ses faces une cavité formée par la demi-coque (10). Cette cavité peut servir de logement pour une batterie par exemple, le fond de la demi-coque comportant des ouvertures pour laisser passer des contacts situés sur la face interne du composant électronique (4).

La figure 7 représente un cas où les dimensions du matériau compressible (9) sont choisies de telle façon à correspondre à celles du contour intérieur du cadre (3).

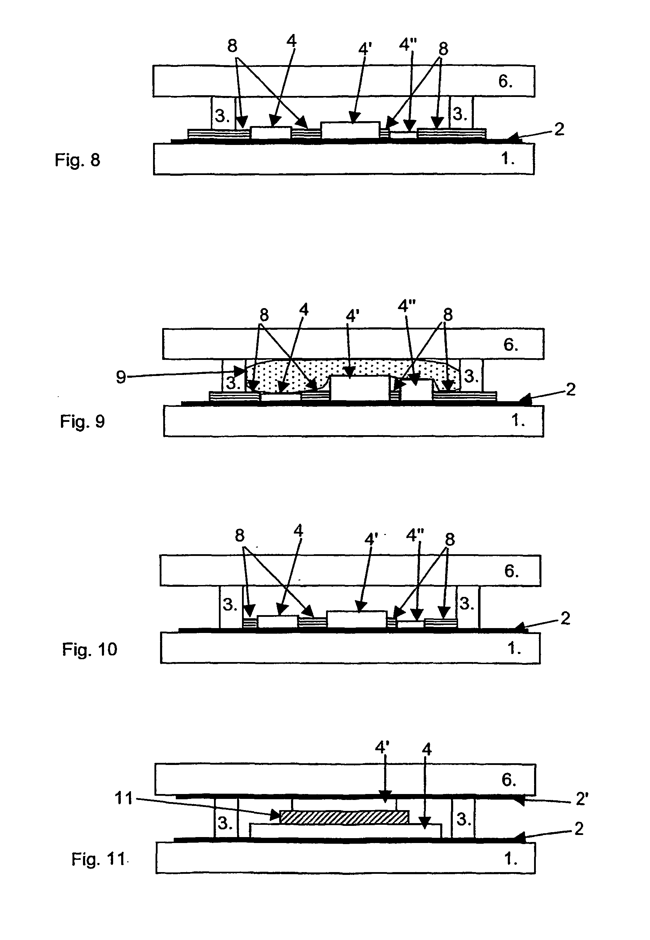

La figure 8 montre une variante où plusieurs composants électroniques (4, 4', 4") de petite taille sont logés dans des fenêtres formées dans une feuille de matière isolante (8) appelée structure de positionnement. Cette structure (8), disposée sur la feuille de protection (2) groupe les composants (4, 4', 4") dans une position bien définie en empêchant leur dispersion lors de l'injection du liant dans le moule. La surface de cette structure de positionnement (8) occupe tout ou partie de la surface de la feuille de protection (2), le cadre (3) étant posé sur la structure de positionnement (8). La surface extérieure de cette dernière peut porter un décor apparaissant sur le module fini. Lorsque la structure de positionnement (8) dépasse le contour extérieur du cadre (3), une étape de finition du contour du module s'avère nécessaire par étampage par exemple.

La figure 9 illustre une variante de la figure 6 où les composants (4, 4', 4") sont recouverts par un matériau compressible (9) occupant toute la surface délimitée par le contour intérieur du cadre (3). Le maintien des composants (4, 4', 4") contre la feuille de protection (2) est ainsi amélioré par la pression exercée sur la plaque de pressage (6) agissant sur le matériau compressible (9).

La figure 10 montre une variante où la structure de positionnement (8) occupe tout ou partie de la surface délimitée par le contour intérieur du cadre (3). Ce dernier étant posé sur la feuille de protection (2). Dans une variante non illustrée, un matériau compressible peut recouvrir les composants électroniques afin d'améliorer le maintien de l'ensemble composants - structure de positionnement par la pression sur la plaque de pressage (6).

La figure 11 illustre un posage pour la fabrication d'un module comprenant des composants électroniques (4, 4') dont une face doit apparaître sur chaque face du module. Une première feuille de protection (2) est posée sur la plaque de base (1). Le cadre (3) est posé sur la feuille de protection (2). A l'intérieur du cadre (3) un premier composant (4) est positionné sur lequel un matériau compressible (11) est superposé. Un second composant (4') est positionné sur le matériau compressible (11) sur lequel une seconde feuille de protection (2') est posée. Cette feuille a une surface au moins équivalente à celle délimitée par le contour extérieur du cadre (3) de façon à éviter tout écoulement du liant sur la face du composant (4') qui doit apparaître sur la face du module. La hauteur totale atteinte par la superposition des composants (4, 4') et le matériau compressible (11) excède l'épaisseur du cadre. L'épaisseur du matériau compressible est donc choisie afin d'assurer une pression suffisante sur l'ensemble avec la plaque de pressage (6) qui ferme le moule.

Une autre variante non illustrée du procédé consiste à:
- placer le cadre (3) sur la plaque de base (1),
- poser la feuille de protection (2) à l'intérieur du cadre (3), la surface de la feuille de protection (2) occupe tout ou partie de la surface délimitée par le contour intérieur du cadre (3). La feuille de protection (2) adhère à la plaque de base par exemple au moyen de colle ou par attraction électrostatique.
- poser sur la feuille de protection au moins un composant électronique (4)
- appuyer la plaque de pressage (6) sur le pourtour du cadre afin de fermer le moule.

Le liant est ensuite introduit par les orifices (5) ad hoc du cadre (3), puis solidifié.

Afin d'empêcher l'infiltration de liant sur la face utile du composant qui doit apparaître à la surface du module, les dimensions de la feuille de protection doivent être égales ou supérieures à celles du composant, ce dernier étant placé entièrement sur la feuille de protection.

Cette variante peut s'appliquer par exemple dans le cas d'un module où la surface apparente du composant doit être en léger retrait par rapport à la surface du module.

Ce retrait équivaut à l'épaisseur de la feuille de protection disposée à l'intérieur du cadre sans pour autant occuper toute la surface intérieure de celui-ci.

Après la solidification du liant, le moule est démonté par enlèvement des plaques de base (1) et de pressage (6). L'enlèvement du cadre (3) est optionnel et dépend de la forme et/ou de la finition du module désirées. La feuille de protection (2) est retirée en dernier, soit avant la finition des faces du module, soit après le montage du module dans un appareil par exemple. Cette feuille peut servir de protection du composant lors des manipulations du module. Par exemple, elle empêche les rayures sur la surface transparente d'un affichage.

Une étape finale facultative du processus de fabrication des modules après leur démoulage consiste à appliquer un film de matière plastique sur une ou chaque face du module. Ce film, servant de décor, comporte les fenêtres nécessaires pour laisser apparaître les faces utiles de composants tels qu'un affichage, des cellules solaires, des touches, etc.

## Revendications

1. Procédé de fabrication d'un module électronique comprenant au moins un composant électronique (4) et une couche formée par un liant, le composant électronique (4), étant partiellement noyé dans la masse rigide formée par le liant solidifié, présente une face apparente à la surface du module, les faces extérieures dudit module étant sensiblement planes, **caractérisé en ce qu'**il comporte les étapes suivantes:
- disposer une feuille de protection (2) sur une plaque de base (1),
- poser un cadre (3) sur ladite feuille de protection (2), ledit cadre (3) définit la forme finale du module, l'épaisseur du cadre (3) est déterminée par la hauteur maximale du composant électronique (4),
- poser sur la feuille de protection (2) et à l'intérieur du cadre (3) au moins un composant électronique (4), la position dudit composant étant maintenue par adhésion sur la feuille de protection (2),
- superposer sur le composant électronique (4) un matériau compressible (7, 9) en recouvrant tout ou partie dudit composant électronique (4),
- appuyer une plaque de pressage (6) sur le pourtour du cadre (3), ladite plaque exerçant une pression sur le matériau compressible (7, 9),
- introduire un liant entre la feuille de protection (2) et la plaque de pressage (6) au travers d'orifices (5) prévus à cet effet dans le cadre (3), ledit liant enrobant le composant électronique (4), et remplissant l'espace défini par le cadre (3), la feuille de protection (2) et la plaque de pressage (6),
- solidifier le liant, ledit liant formant une couche rigide maintenant le composant électronique (4),
- enlever la plaque de base (1) et la plaque de pressage (6) après solidification du liant.

2. Procédé de fabrication selon la revendication 1, **caractérisé en ce que** la feuille de protection (2) comporte une substance adhésive sur tout ou partie de sa surface, le composant électronique (4) étant posé sur les zones adhésives de la surface de la feuille de protection (2).

3. Procédé de fabrication selon la revendication 1, **caractérisé en ce que** le cadre (3) est posé sur la plaque de base, la feuille de protection (2) est disposée à l'intérieur du cadre (3), ladite feuille (2), occupant tout ou partie de la surface délimitée par le contour intérieur du cadre (3), est maintenue par adhésion sur la plaque de base (1), le composant électronique (4) est placé entièrement sur la feuille de protection (2), ladite feuille maintient le composant (4) par adhésion.

4. Procédé de fabrication selon les revendications 1 à 3, **caractérisé en ce que** l'épaisseur du matériau compressible (7, 9) est déterminée de façon à ce que la pression appliquée sur la plaque de pressage (6) agisse sur le composant électronique (4).

5. Procédé de fabrication, selon les revendication 1 à 4, **caractérisé en ce que** le matériau compressible (7) est disposé à l'intérieur d'une demi-coque (10), ladite demi-coque (10) se plaçant sur le composant électronique (4); la hauteur des parois de la demi-coque (10) correspondant à la hauteur de l'espace séparant le composant électronique (4) de la plaque de pressage (6), le liant introduit par les orifices (5) du cadre (3) se répartit dans l'espace libre délimité par les parois du cadre (3), les plaques de base (1) et de pressage (6) et les parois de la demi-coque (10), ledit liant ne pénétrant pas à l'intérieur de la demi-coque (10) où se trouve le matériau compressible (7), après solidification du liant, les plaques de base (1) et de pressage (6) sont démontées et le matériau compressible (7) est enlevé de l'intérieur de la demi-coque (10).

6. Procédé de fabrication selon la revendication 1 à 4, **caractérisé en ce que** le matériau compressible (7, 9) occupe toute la surface délimitée par le contour intérieur du cadre (3).

7. Procédé de fabrication selon la revendication 1, **caractérisé en ce qu'**une structure de positionnement (8) est disposée sur la feuille de protection (2), ladite structure de positionnement occupe tout ou partie de la surface de la feuille de protection (2), ladite structure (8) comporte au moins une fenêtre dans laquelle est logé le composant électronique (4, 4', 4"), ledit composant (4, 4', 4") est maintenu par la feuille de protection (2) et la structure de positionnement (8).

8. Procédé de fabrication selon la revendication 7, **caractérisé en ce que** le cadre (3) est posé sur la structure de positionnement (8) et **en ce qu'**une étape finale, après solidification du liant, consiste à ajuster le contour de ladite structure de positionnement (8) à la dimension du module final.

9. Procédé de fabrication selon la revendication 7, **caractérisé en ce que** la structure de positionnement (8) occupe tout ou partie de la surface de la feuille de protection (2) délimitée par le contour intérieur du cadre (3), ledit cadre (3) étant posé sur la feuille de protection (2).

10. Procédé de fabrication selon les revendications 7 à 9, **caractérisé en ce que** le cadre (3) est solidaire de la structure de positionnement (8), l'ensemble ainsi formé constituant une cavité, le fond de ladite cavité correspondant à la structure de positionnement (8) et les parois latérales correspondant au cadre (3).

11. Procédé de fabrication selon les revendications 7 à 10, **caractérisé en ce que** la face extérieure de la structure de positionnement (8) fait office de décor.

12. Procédé de fabrication selon les revendications 7 à 11, **caractérisé en ce qu'**un matériau compressible (7, 9) est superposé sur la structure de positionnement (8) dans laquelle est logé le composant électronique (4, 4', 4").

13. Procédé de fabrication d'un module électronique, selon l'une des revendications précédentes, **caractérisé en ce qu'**un second composant électronique (4') est superposé sur le premier composant électronique (4), lesdits composants sont séparés par un matériau compressible (7, 9, 11), le second composant (4') est recouvert par une seconde feuille de protection (2') en appui sur la plaque de pressage, ladite seconde feuille ayant une surface au moins équivalente à celle délimitée par le contour extérieur du cadre (3).

14. Procédé de fabrication selon les revendications précédentes, **caractérisé en ce que** le cadre (3) est enlevé après solidification du liant et l'ouverture des plaques de base (1) et de pressage (6).

15. Procédé de fabrication d'un module électronique selon les revendications 1 à 12, **caractérisé en ce que** le cadre (3) fait partie intégrante du module et est conservé après solidification du liant et l'ouverture des plaques de base (1) et de pressage (6).

16. Procédé de fabrication selon les revendications précédentes, **caractérisé en ce que** la feuille de protection (2, 2') n'est enlevée que lors de l'utilisation finale du module, ladite feuille protège le composant électronique (4, 4', 4") lors des manipulations du module.

17. Procédé de fabrication d'un module électronique, selon la revendication 1, **caractérisé en ce qu'**un film de matière plastique est appliqué sur une ou chaque face du module fini, ledit film, servant de décor, comporte les fenêtres nécessaires pour laisser apparaître les faces utiles des composants électroniques (4, 4', 4").

## Claims

1. Method for manufacturing a module comprising at least one electronic component (4) and a layer formed by a binder, the electronic component (4) being partially embedded in a rigid mass formed by the solidified binder, presents a visible face on the module surface, the outer faces of said module being sensibly flat,
**characterized in that** it includes the following steps:
- placing of a protection sheet (2) on a base plate (1),
- placing a frame (3) on said protection sheet (2), said frame defines the final shape of the module; the thickness of the frame (3) is determined by the maximum height of the electronic component (4),
- putting on the protection sheet (2) and inside the frame (3) at least one electronic component (4), the position of said component being maintained by adhesion on the protection sheet (2),
- superimposing a compressible material on the electronic component (4) to cover all or part of said electronic component (4),
- leaning a pressing plate (6) on the outline of the frame (3), said plate exerting a pressure on the compressible material (7,9),
- introducing a binder between the protection sheet (2) and the pressing plate (6) through orifices (5) provided for that purpose in the frame (3), said binder encapsulating the electronic component (4) and filling the space defined by the frame (3), the protection sheet (2) and the pressing plate (6),
- solidifying the binder, said binder forming a rigid layer maintaining the electronic component (4),
- removing the base plate (1) and the pressing plate (6) after solidification of the binder.

2. Method for manufacturing according to claim 1, **characterized in that** the protection sheet (2) includes an adhesive substance on all or part of its surface, the electronic component (4) being placed on the adhesive zones of the protection sheet surface (2).

3. Method for manufacturing according to claim 1, **characterized in that** the frame (3) is placed on the base plate, the protection sheet (2) is placed inside the frame (3), said sheet (2), occupying all or part of the surface delimited by the inner outline of the frame (3), is maintained by adhesion on the base plate (1), the electronic component (4) is entirely placed on the protection sheet (2), said sheet maintains the component (4) by adhesion.

4. Method for manufacturing according to claims 1 to 3, **characterized in that** the thickness of the compressible material (7, 9) is determined in such a way to make the pressure applied on the pressing plate (6) act on the electronic component (4).

5. Method for manufacturing according to claims 1 to 4, **characterized in that** the compressible material (7) is placed inside a semi-shell (10), said semi-shell (10) is placed on the electronic component (4), the height of the semi-shell walls (10) corresponding to the height of the space separating the electronic component (4) from the pressing plate (6), the binder introduced by the orifices (5) of the frame (3) spreads in free space delimited by the frame walls (3), the base (1) and pressing (6) plates and the semi-shell walls (10), said binder does not penetrate inside the semi-shell (10) where is the compressible material (7), after solidification of the binder, the base (1) and pressing plates (6) are dismounted and the compressible material (7) is removed from the inside of the semi-shell (10).

6. Method for manufacturing according to claim 1 to 4, **characterized in that** the compressible material (7, 9) occupies the whole surface delimited by the inner outline of the frame (3).

7. Method for manufacturing according to claim 1, **characterized in that** a positioning structure (8) is placed on the protection sheet (2), said positioning structure occupies all or part of the surface of the protection sheet (2), said structure (8) includes at least one window in which is housed the electronic component (4, 4', 4"), said component (4, 4', 4") is maintained by the protection sheet (2) and the positioning structure (8).

8. Method for manufacturing according to claim 7, **characterized in that** the frame (3) is placed on the positioning structure (8) and **in that** a final step, after solidification of the binder, consists in adjusting the outline of said placement structure (8) to the final module size.

9. Method for manufacturing according to claim 7, **characterized in that** the positioning structure (8) occupies all or part of the surface of the protection sheet (2) delimited by the inner outline of the frame (3), said frame (3) being placed on the protection sheet (2).

10. Method for manufacturing according to claims 7 to 9, **characterized in that** the frame (3) is integral with the positioning structure (8), the set thus formed constituting a cavity, the bottom of said cavity corresponding to the positioning structure (8) and the side walls corresponding to the frame (3).

11. Method for manufacturing according to claims 7 to 10, **characterized in that** the external face of the positioning structure (8) is used as decoration.

12. Method for manufacturing according to claims 7 to 11, **characterized in that** a compressible material (7, 9) is superimposed on the positioning structure (8) in which is housed the electronic component (4, 4', 4").

13. Method for manufacturing of an electronic module according to one of the previous claims, **characterized in that** a second electronic component (4') is superimposed on the first electronic component (4), said components are separated by a compressible material (7, 9, 11), the second component (4') is covered by a second protection sheet (2') in support on the pressing plate, said second sheet having a surface at least equivalent to the one delimited by the external outline of the frame (3).

14. Method for manufacturing according to the previous claims, **characterized in that** the frame (3) is removed after solidification of the binder and the opening of the base (1) and pressing (6) plates.

15. Method for manufacturing of an electronic module according to claims 1 to 12, **characterized in that** the frame (3) is a part of the module and is kept after solidification of the binder and the opening of the base (1) and pressing (6) plates.

16. Method for manufacturing according to the previous claims, **characterized in that** the protection sheet (2, 2') is removed only during the final use of the module, said sheet protects the electronic component (4, 4', 4") during module manipulations.

17. Method for manufacturing of an electronic module, according to claim 1, **characterized in that** a plastic material film is applied on one or each face of the finished module, said film, serving as decoration, includes the windows necessary to let appear the electronic components useful faces (4, 4', 4").

## Patentansprüche

1. Fertigungsverfahren für einen elektronischen Modul mit zumindest einem elektronischen Bauteil (4) und einer von einem Bindemittel gebildeten Schicht, wobei das teilweise in die durch das erstarrte Bindemittel gebildete starre Masse eingebettete elektronische Bauteil (4) eine an der Oberfläche des Moduls hervortretende Seite aufweist und die Aussenseiten des Moduls im Wesentlichen eben sind, **dadurch gekennzeichnet, dass** es die folgenden Schritte umfasst:
- Auslegen einer Schutzfolie (2) auf eine Grundplatte (1),
- Auflegen eines Rahmens (3) auf diese Schutzfolie (2), wobei der Rahmen (3) die endgültige Gestalt des Moduls definiert, während die Dicke des Rahmens (3) durch die maximale Höhe des elektronischen Bauteils (4) bestimmt wird,
- Auflegen zumindest eines elektronischen Bauteils (4) auf die Schutzfolie (2) innerhalb des Rahmens (3), wobei die Lage dieses Bauteils durch Haftung auf der Schutzfolie (2) beibehalten wird,
- Darüberlegen eines zusammendrückbaren Materials (7, 9) über das elektronische Bauteil (4), wobei das elektronische Bauteil (4) ganz oder teilweise abgedeckt wird,
- Andrücken einer Druckplatte (6) auf die Peripherie des Rahmens (3), wobei diese Platte einen Druck auf das zusammendrückbare Material (7, 9) ausübt,
- Einführen eines Bindemittels zwischen die Schutzfolie (2) und die Druckplatte (6) über Löcher (5), die dazu im Rahmen (3) vorgesehen sind, wobei das Bindemittel das elektronische Bauteil (4) umhüllt und den durch den Rahmen (3), die Schutzfolie (2) und die Druckplatte (6) definierten Raum ausfüllt,
- Erstarren des Bindemittels, wobei das Bindemittel eine starre, das elektronische Bauteil (4) haltende Schicht bildet,
- Abnehmen der Grundplatte (1) und der Druckplatte (6) nach Erstarren des Bindemittels.

2. Fertigungsverfahren nach Anspruch 1, **dadurch gekennzeichnet, dass** die Schutzfolie (2) auf ihrer ganzen oder einem Teil ihrer Oberfläche eine Haftsubstanz umfasst, wobei das elektronische Bauteil (4) auf die haftenden Bereiche der Oberfläche der Schutzfolie (2) aufgelegt wird.

3. Fertigungsverfahren nach Anspruch 1, **dadurch gekennzeichnet, dass** der Rahmen (3) auf die Grundplatte gelegt, die Schutzfolie (2) innerhalb des Rahmens (3) angeordnet und diese Folie (2), die die ganze oder einen Teil der durch die Innenkontur des Rahmens (3) begrenzte Fläche einnimmt, durch Haftung auf der Grundplatte (1) gehalten wird, das elektronische Bauteil (4) ganz auf die Schutzfolie (2) aufgesetzt wird und die Folie das Bauteil (4) durch Haftung hält.

4. Fertigungsverfahren nach Ansprüchen 1 bis 3, **dadurch gekennzeichnet, dass** die Dicke des zusammendrückbaren Materials (7, 9) so festgelegt wird, dass der auf die Druckplatte (6) ausgeübte Druck auf das elektronische Bauteil (4) wirkt.

5. Fertigungsverfahren nach Ansprüchen 1 bis 4, **dadurch gekennzeichnet, dass** das zusammendrückbare Material (7) innerhalb einer Halbschale (10) angeordnet wird, wobei die Halbschale (10) sich über das elektronische Bauteil (4) legt, die Höhe der Wandungen der Halbschale (10) der Höhe des Raumes zwischen dem elektronischen Bauteil (4) und der Druckplatte (6) entspricht, das durch die Öffnungen (5) des Rahmens (3) eingeführte Bindemittel sich in dem durch die Wandungen des Rahmens (3), die Grundplatte (1), die Druckplatte (6) und die Wandungen der Halbschale (10) begrenzten freien Raum verteilt, das Bindemittel aber nicht ins Innere der Halbschale (10) eindringt, wo sich das zusammendrückbare Material (7) befindet, die Grundplatte (1) und die Druckplatte (6) nach Erstarren des Bindemittels abmontiert werden und das zusammendrückbare Material (7) aus dem Inneren der Halbschale (10) entfernt wird.

6. Fertigungsverfahren nach Ansprüchen 1 bis 4, **dadurch gekennzeichnet, dass** das zusammendrückbare Material (7, 9) die ganze durch die Innenkontur des Rahmens (3) begrenzte Oberfläche einnimmt.

7. Fertigungsverfahren nach Anspruch 1, **dadurch gekennzeichnet, dass** eine Positionierstruktur (8) auf der Schutzfolie (2) angeordnet ist, wobei die Positionierstruktur die ganze oder einen Teil der Oberfläche der Schutzfolie (2) einnimmt, die Struktur (8) zumindest ein Fenster umfasst, in dem das elektronische Bauteil (4, 4', 4") untergebracht ist, und das Bauteil (4, 4', 4") durch die Schutzfolie (2) und die Positionierstruktur (8) gehalten wird.

8. Fertigungsverfahren nach Anspruch 7, **dadurch gekennzeichnet, dass** der Rahmen (3) auf die Positionierstruktur (8) aufgesetzt wird und dass ein abschliessender Schritt nach Erstarren des Bindemittels darin besteht, die Kontur der Positionierstruktur (8) an die Abmessungen des fertigen Moduls anzupassen.

9. Fertigungsverfahren nach Anspruch 7, **dadurch gekennzeichnet, dass** die Positionierstruktur (8) die ganze oder einen Teil der Oberfläche der Schutzfolie (2) einnimmt, die durch die Innenkontur des Rahmens (3) begrenzt wird, wobei der Rahmen (3) auf die Schutzfolie (2) aufgesetzt wird.

10. Fertigungsverfahren nach Ansprüchen 7 bis 9, **dadurch gekennzeichnet, dass** der Rahmen (3) fest mit der Positionierstruktur (8) verbunden ist, wobei die so gebildete Baugruppe eine Vertiefung darstellt, der Boden dieser Vertiefung der Positionierstruktur (8) entspricht und die Seitenwände dem Rahmen (3) entsprechen.

11. Fertigungsverfahren nach Ansprüchen 7 bis 10, **dadurch gekennzeichnet, dass** die Aussenseite der Positionierstruktur (8) als Dekoration dient.

12. Fertigungsverfahren nach Ansprüchen 7 bis 11, **dadurch gekennzeichnet, dass** ein zusammendrückbares Material (7, 9) über die Positionierstruktur (8) gelegt wird, in der das elektronische Bauteil (4, 4', 4") untergebracht ist.

13. Fertigungsverfahren für einen elektronischen Modul nach einem der vorangehenden Ansprüche, **dadurch gekennzeichnet, dass** ein zweites elektronisches Bauteil (4') über das erste elektronische Bauteil (4) gelegt wird, die Bauteile durch ein zusammendrückbares Material (7, 9, 11) voneinander getrennt sind, das zweite Bauteil (4') von einer zweiten Schutzfolie (2') überdeckt wird, die an der Druckplatte anliegt, wobei die zweite Folie eine Fläche besitzt, die zumindest der durch die Aussenkontur des Rahmens (3) begrenzten gleichwertig ist.

14. Fertigungsverfahren nach den vorangehenden Ansprüchen, **dadurch gekennzeichnet, dass** der Rahmen (3) nach Erstarren des Bindemittels und Öffnung der Grundplatte (1) sowie der Druckplatte (6) abgenommen wird.

15. Fertigungsverfahren für einen elektronischen Modul nach den Ansprüchen 1 bis 12, **dadurch gekennzeichnet, dass** der Rahmen (3) einen integrierenden Bestandteil des Moduls bildet und nach Erstarren des Bindemittels und Öffnung der Grundplatte (1) sowie der Druckplatte (6) bewahrt wird.

16. Fertigungsverfahren nach den vorangehenden Ansprüchen, **dadurch gekennzeichnet, dass** die Schutzfolie (2, 2') erst beim endgültigen Einsatz des Moduls entfernt wird, wobei die Folie das elektronische Bauteil (4, 4', 4") während der Manipulationen des Moduls schützt.

17. Fertigungsverfahren für einen elektronischen Modul nach Anspruch 1, **dadurch gekennzeichnet, dass** eine Kunststofffolie auf eine oder beide Seiten des fertigen Moduls aufgebracht wird, wobei diese als Dekoration dienende Folie die Fenster umfasst, die erforderlich sind, um die Nutzseiten der elektronischen Bauteile (4, 4', 4") hervortreten zu lassen.
